# EUROPEAN PATENT APPLICATION

(11) **EP 2 955 323 A1**
(43) Date of publication of application: **16.12.2015**
(21) Application number: 14290169.3
(22) Date of filing: 11.06.2014
(51) Int. Cl.: E21B 47/00, G01N 21/00, C30B 25/02

(54) **Diamond window assembly for optical logging**

(71) Applicant: Services Petroliers Schlumberger, 75007 Paris (FR); Schlumberger Holdings Limited, Road Town, Tortola 1110 (VG); Schlumberger Technology B.V., 2514 JG The Hague (NL)
(72) Inventor: Wu, Xu, 92140 Clamart (FR); Luling, Martin, 92140 Clamart (FR)
(74) Representative: Leonori, Céline

(57) **Abstract**

Devices and methods for well logging using a diamond window assembly are provided. A method according to the disclosure includes placing a downhole tool in a wellbore in a geological formation and compressing a window assembly in the downhole tool against the geological formation. The window assembly may include a polycrystalline diamond compound material fused with a monocrystalline diamond window that holds the monocrystalline diamond window in place, despite being compressed against the geological formation. First photonic radiation may be emitted through the monocrystalline diamond window onto the geological formation. Second photonic radiation may be detected through the monocrystalline diamond window. This second photonic radiation may derive from interactions between the first photonic radiation and the geological formation. As such, the second photonic radiation may carry information relating to the composition of the geological formation (e.g., the presence or absence of hydrocarbons).

## Description

### BACKGROUND

This disclosure relates to optical well-logging using a diamond window assembly having a monocrystalline diamond window fused to polycrystalline diamond compound (PDC).

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as an admission of any kind.

Identifying the composition of a geological formation can provide information about the likely presence or absence of hydrocarbons. In fact, identifying fluorescence from cuttings-pieces of the geological formation that are cut by a drill bit-has been used for decades to look for hydrocarbon pay zones in a well. Analyzing the cuttings at the surface, however, may result in a large uncertainty as to the depth where the cuttings originated. As such, many downhole tools have been developed that attempt to analyze the geological formation from within a wellbore. These tools include, among other things, a borehole microscopic imager and/or fluorescence logging tools. By way of example, fluorescence logging involves illuminating the wall of the wellbore with certain frequencies of light through a transparent window in the downhole tool. Interactions with the light by molecules in the wellbore wall may produce new, lower frequencies of light. By detecting new light that results, the downhole tool may identify the presence or absence of hydrocarbons in the geological formation.

But a downhole tool might not operate effectively if the downhole tool cannot "see" the wellbore wall. Indeed, borehole fluid in the wellbore may block the transparent window. If this happens, the downhole tool may emit and detect light not from the geological formation, but rather from the borehole fluid moving through the wellbore. By compressing the transparent window against the wellbore wall, less wellbore fluid may intervene. Applying too much pressure to the transparent window or scraping the transparent window against the wellbore wall, however, may cause the transparent window to erode or break.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

Embodiments of the disclosure relate to well logging using a diamond window assembly. A method according to the disclosure includes placing a downhole tool in a wellbore in a geological formation and compressing a window assembly in the downhole tool against the geological formation. The window assembly may include a polycrystalline diamond compound material fused with a monocrystalline diamond window that holds the monocrystalline diamond window in place, despite being compressed against the geological formation. First photonic radiation may be emitted through the monocrystalline diamond window onto the geological formation. Second photonic radiation may be detected through the monocrystalline diamond window. This second photonic radiation may derive from interactions between the first photonic radiation and the geological formation. As such, the second photonic radiation may carry information relating to the composition of the geological formation (e.g., the presence or absence of hydrocarbons).

In another example, a downhole device includes a window assembly to enable photonic radiation to enter or exit the downhole device and a photonic-radiation-based tool configured to emit or detect, or emit and detect, the photonic radiation through the window assembly during a well logging operation. The window assembly includes a window body, a monocrystalline diamond window, and a polycrystalline diamond compound material. The window body has a transparent interior portion that is substantially transparent to the photonic radiation. The monocrystalline diamond window may be disposed over the transparent interior portion of the window body. The polycrystalline diamond compound material may be disposed around the monocrystalline diamond window on the window body, such that the polycrystalline diamond compound is fused with the monocrystalline diamond window to hold the monocrystalline diamond window in place without any additional intervening adhesive material.

Moreover, a method for manufacturing such a diamond window assembly for photonic-radiation-based logging may include loading diamond powders over a monocrystalline diamond disposed on a window body, sintering the diamond powders to form a polycrystalline diamond compound that fuses with the monocrystalline diamond to hold the monocrystalline diamond in place, and removing excess polycrystalline diamond compound on the monocrystalline diamond by grinding, or polishing, or both grinding and polishing.

Various refinements of the features noted above may be undertaken in relation to various aspects of the present disclosure. Further features may also be incorporated in these various aspects as well. These refinements and additional features may exist individually or in any combination. For instance, various features discussed below in relation to one or more of the illustrated embodiments may be incorporated into any of the above-described aspects of the present disclosure alone or in any combination. The brief summary presented above is intended to familiarize the reader with certain aspects and contexts of embodiments of the present disclosure without limitation to the claimed subject matter.

### BRIEF DESCRIPTION OF THE DRAWINGS

Various aspects of this disclosure may be better understood upon reading the following detailed description and upon reference to the drawings in which:
FIG. 1 is a schematic diagram of a drilling system that includes an optical logging tool with a diamond window assembly having a monocrystalline diamond window, in accordance with an embodiment;
FIG. 2 is a schematic view of a downhole optical tool that includes the diamond window assembly, in accordance with an embodiment;
FIG. 3 is a flowchart of a method for using the downhole optical tool, in accordance with an embodiment;
FIG. 4 is a schematic view of the diamond window assembly, in accordance with an embodiment;
FIG. 5 is a flowchart of a method for manufacturing the diamond window assembly of FIG. 4, in accordance with an embodiment;
FIGS. 6 and 7 are schematic diagrams showing partially completed diamond window assemblies during the manufacturing process of FIG. 5, in accordance with an embodiment;
FIG. 8 is another example of a diamond window assembly that has a rim groove, in accordance with an embodiment;
FIG. 9 is a schematic view of another diamond window assembly that employs a spheroid monocrystalline diamond window, in accordance with an embodiment;
FIG. 10 is a schematic view of another diamond window assembly that employs a monocrystalline diamond window having outwardly angled lateral edges, in accordance with an embodiment;
FIG. 11 is a schematic view of another diamond window assembly that employs a monocrystalline diamond window having inwardly angled lateral edges, in accordance with an embodiment;
FIG. 12 is a schematic view of another diamond window assembly that employs a monocrystalline diamond window having a groove within its lateral edges, in accordance with an embodiment;
FIG. 13 is a flowchart of another method for manufacturing the diamond window assembly of FIG. 4, in accordance with an embodiment; and
FIGS. 14 and 15 are schematic diagrams showing partially completed diamond window assemblies during the manufacturing process of FIG. 13, in accordance with an embodiment.

### DETAILED DESCRIPTION

One or more specific embodiments of the present disclosure will be described below. These described embodiments are examples of the presently disclosed techniques. Additionally, in an effort to provide a concise description of these embodiments, features of an actual implementation may not be described in the specification. It should be appreciated that in the development of any such actual implementation, as in any engineering or design project, numerous implementation-specific decisions may be made to achieve the developers' specific goals, such as compliance with system-related and business-related constraints, which may vary from one implementation to another. Moreover, it should be appreciated that such a development effort might be complex and time consuming, but would be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

One way to identify hydrocarbon pay zones in a geological formation is through optical well logging. Optical well logging, as described in this disclosure, relates to using light to identify characteristics of the geological formation. The light used in optical logging may or may not be within the spectrum of light that is visible to humans. Indeed, the light may be in the visible spectrum (e.g., blue or green light), but could also be lower (e.g., infrared) or higher (e.g., ultraviolet). In fluorescence logging, for example, relatively higher-energy light (e.g., ultraviolet or blue to green light) is emitted through a transparent window in an optical logging tool. Aromatic molecules in the geological formation, such as reservoir oil, may absorb the higher-energy light and re-emit lower-energy light (e.g., yellow or red to infrared light). The lower-energy light emitted by the aromatic molecules may be detected through the transparent window. Hence, with fluorescence logging, the presence of reservoir oil can be identified with a thin-bed resolution of a few millimeters. The optical well logging referred to in this disclosure may, additionally or alternatively, make use of other frequencies of electromagnetic radiation that can pass through the diamond window assembly. These other frequencies may include, for example, x-rays or gamma-rays that can be used to perform measurements of density or other geological properties.

As noted above, a downhole tool may not be able to predict the properties of the geological formation if the downhole tool cannot "see" the wellbore wall. Indeed, borehole fluid in the wellbore may block the transparent window from wellbore wall. If this happens, the downhole tool may emit and detect light not from the geological formation on the wellbore wall, but rather from the borehole fluid moving through the wellbore. By compressing the transparent window against the wellbore wall, less wellbore fluid may intervene.

To ensure the integrity of the transparent window while the window is being compressed against the wellbore wall, the transparent window may be formed using a monocrystalline diamond window held in place by a surrounding polycrystalline diamond compound (PDC). The PDC and the monocrystalline diamond may fuse together into a material having a substantially uniform hardness. The combined PDC and monocrystalline diamond structure of the transparent window may be less likely to erode or break when pressed against the geological formation. Indeed, the transparent window may scrape against the geological formation during a logging-while-drilling operation (LWD) without eroding or breaking. Moreover, PDC alone may not be as transparent as desired. Thus, the transparent monocrystalline diamond that is held in place by the PDC may permit light to pass more easily than the PDC, and the fused nature of the PDC and monocrystalline diamond may provide a substantially integral diamond window that can withstand the severe stress of the downhole environment. The transparent window may be located, for example, on a stabilizer blade of a borehole assembly (BHA) or even on a drill bit of the BHA.

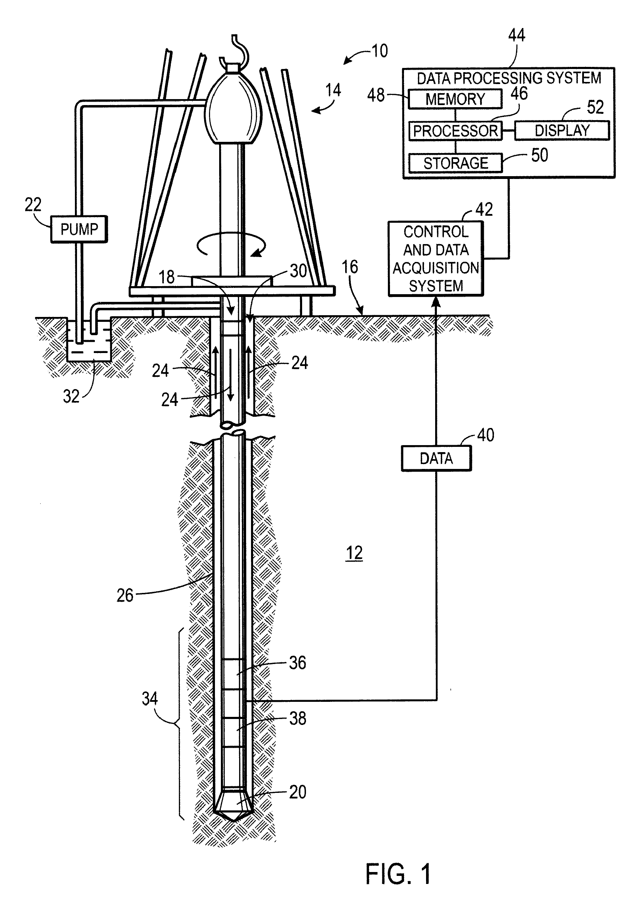

With this in mind, FIG. 1 illustrates a drilling system 10 that includes an optical logging tool with such a transparent diamond window. The drilling system 10 may be used to drill a well into a geological formation 12 and obtain optical logging measurements useful to identify characteristics of the well. In the drilling system 10, a drilling rig 14 at the surface 16 may rotate a drill string 18 having a drill bit 20 at its lower end. As the drill bit 20 is rotated, a drilling fluid pump 22 is used to pump drilling fluid 23, which may be referred to as "mud" or "drilling mud," downward through the center of the drill string 18 in the direction of the arrow to the drill bit 20. The drilling fluid 23, which is used to cool and lubricate the drill bit 20, exits the drill string 18 through the drill bit 20. The drilling fluid 23 then carries drill cuttings away from the bottom of a wellbore 26 as it flows back to the surface 16, as shown by the arrows through an annulus 30 between the drill string 18 and the formation 12. However, as described above, as the drilling fluid 23 flows through the annulus 30 between the drill string 18 and the formation 12, the drilling mud 23 may begin to invade and mix with the fluids stored in the formation, which may be referred to as formation fluid (e.g., natural gas or oil). At the surface 16, return drilling fluid 24 is filtered and conveyed back to a mud pit 32 for reuse.

As illustrated in FIG. 1, the lower end of the drill string 18 includes a bottom-hole assembly (BHA) 34 that may include the drill bit 20 along with various downhole tools. The downhole tools may collect a variety of information relating to the geological formation 12 and/or the state of drilling of the well. For instance, a measurement-while-drilling (MWD) tool 36 may measure certain drilling parameters, such as the temperature, pressure, orientation of the drilling tool, and so forth. Likewise, a logging-while-drilling (LWD) tool 38 may measure the physical properties of the geological formation 12, such as density, porosity, resistivity, lithology, and so forth. The MWD tool 36 and/or the LWD tool 38 may include an optical logging tool that emits and/or detects light through a diamond window assembly. In certain embodiments, the diamond window assembly may be located on a stabilizer blade of the BHA or even the drill bit 20.

The MWD tool 36 and/or the LWD tool 38 may collect a variety of data 40 that may be stored and processed in the BHA or, as illustrated in FIG. 1, may be sent to the surface for processing. In the example of this disclosure, the MWD tool 36 and/or the LWD tool 38 may include an optical logging tool that emits and/or detects light through a diamond window assembly. The data 40 that is collected may include counts and/or detected energies of photons of light that return to the optical logging tool that may contain information relating to characteristics of the geological formation 12. The data 40 may be sent via a control and data acquisition system 42 to a data processing system 44. The control and data acquisition system 42 may receive the data 40 in any suitable way. In one example, the control and data acquisition system 42 may transfer the data 40 via electrical signals pulsed through the geological formation 12 or via mud pulse telemetry using the drilling fluid 24. In another example, the data 40 may be retrieved directly from the MWD tool 36 and/or the LWD tool 38 upon return to the surface.

The data processing system 44 may include a processor 46, memory 48, storage 50, and/or a display 52. The data processing system 44 may use the data 40 to determine various properties of the well using any suitable techniques. As will be discussed further below, the MWD tool 36 and/or LWD tool 38 may obtain a better optical signal than otherwise by compressing a diamond window against the geological formation 12 without erosion or breakage of the window. Thus, when the data processing system 44 processes the data 40, the determined well properties may be more accurate and/or precise than otherwise. To process the data 40, the processor 46 may execute instructions stored in the memory 48 and/or storage 50. As such, the memory 48 and/or the storage 50 of the data processing system 44 may be any suitable article of manufacture that can store the instructions. The memory 46 and/or the storage 50 may be ROM memory, random-access memory (RAM), flash memory, an optical storage medium, or a hard disk drive, to name a few examples. The display 52 may be any suitable electronic display that can display the logs and/or other information relating to properties of the well as measured by the MWD tool 36 and/or the LWD tool 38. It should be appreciated that, although the data processing system 44 is shown by way of example as being located at the surface, the data processing system 44 may be located in the MWD tool 36 and/or the LWD tool 38. In such embodiments, some of the data 40 may be processed and stored downhole, while some of the data 40 may be sent to the surface in real time. This may be the case particularly in LWD, where a limited amount of the data 40 may be transmitted to the surface during drilling or reaming operations.

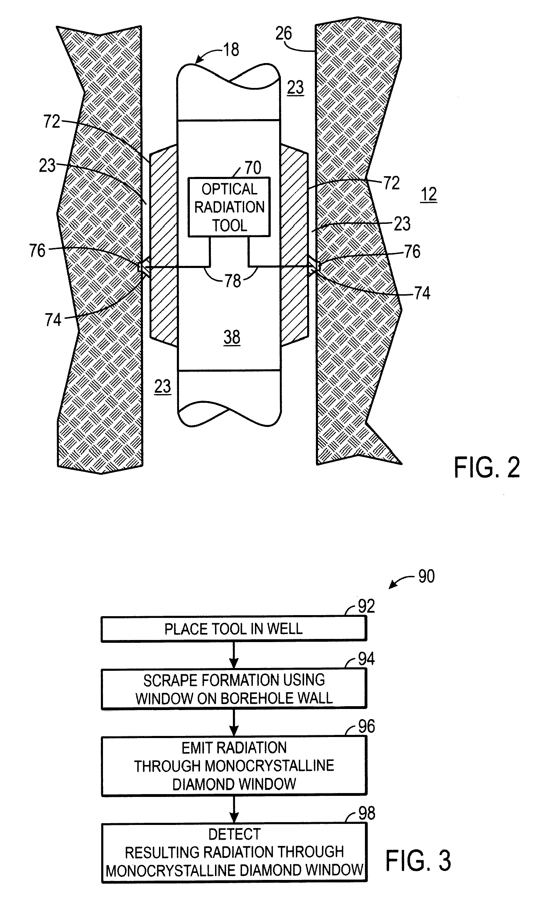

It should be noted that, although the optical tool of this disclosure is described by way of example in a logging-while-drilling (LWD) configuration, any other suitable means of conveyance may be employed (e.g., wireline, slickline, coiled tubing, and so forth). One example of the LWD configuration appears in FIG. 2, which illustrates an example close view of the LWD tool 38 of the drill string 18 shown in FIG. 1. The LWD tool 38 of FIG. 2 is shown to be inside the wellbore 26, which is filled with the drilling mud 23 and with other fluids that may be collectively known as borehole fluid. To enable light to pass to and from the geological formation 12 for optical measurements by the optical radiation tool 70, stabilizer blades 72 on the LWD tool 38 may include a light-transmissive window assembly 74 that protrudes from the stabilizer blades 72 by some distance (e.g., 1-5 mm). In the example of FIG. 2, there are two window assemblies 74, but an actual implementation may include more or fewer window assemblies 74. Each window assembly 74 may include a monocrystalline diamond window 76. The monocrystalline diamond window 76 may represent a synthetic diamond of any suitable shape, such as a disk or spheroid. Light guides 78, which may include one or more optical fibers, may transmit light to and/or from the optical radiation tool 70 and each monocrystalline diamond window 76. Additionally or alternatively, light emitters and/or detectors of the optical radiation tool 70 may be disposed adjacent to the window assemblies 74. The optical radiation tool 70 may be any suitable tool that uses light to determine properties of the geological formation 12. For example, the optical radiation tool 70 may be a fluorescence logging tool and/or a borehole microscopic imager, to name a few examples.

Although the window assemblies 74 of FIG. 2 are shown to be attached to the stabilizer blades 72 of the LWD tool 38, the window assemblies 74 may be installed any suitable location that allows them to be compressed against the geological formation 12. For instance, the window assemblies 74 may, additionally or alternatively, appear on other stabilizer blades located elsewhere on the drill string 18. Moreover, because of their strength, the window assemblies 74 even may be installed on the drill bit 20. In a non-LWD embodiment of the optical logging tool 70, the window assemblies may be installed a surface of such a tool that contacts the geological formation 12.

A flowchart 90 of FIG. 3 provides an example of how the optical radiation tool 70 may identify properties of the geological formation 12. The flowchart 90 begins when the optical radiation tool 70 is placed into the well (block 92). Using the LWD tool 38 shown in FIG. 2 as an example, the optical radiation tool 70 may be placed into the well when the drill string 18 is used to drill the well. Any standoff or gap between the window assemblies 74 and the wall of the wellbore 26 may be filled with opaque mud or mud filtrate in the borehole fluid 23, which could severely impede an optical measurement. The penetration of visible light through mud is on the order of micrometers (10⁻⁶ m). Borehole rugosity alone could prevent a satisfactory optical measurement-thus, to prevent a gap between the window assemblies 74 and the wellbore 26 wall, the window assemblies 74 may scrape the geological formation 12 as the drill string 18 rotates (block 94). For example, when the measurement moves from one location in the wellbore 26 to the next, the window assemblies 74, dragged by the drill string 18, may scrape the geological formation 12 with their leading edges. This may prepare a flat sample surface for the next optical measurement before borehole fluid 23 has had a chance to interfere. Under these conditions, the optical radiation tool 70 may emit first optical photonic radiation (light) through the monocrystalline diamond windows 76 of the window assemblies 74 (block 96). The emitted light may interact with elements and molecules of the geological formation 12 to produce second optical photonic radiation (light) that may be detected through the monocrystalline diamond windows 76 of the window assemblies 74 (block 98). The amount and characteristics of the detected light may correspond with the particular elements or molecules of the geological formation 12 and, thus, may carry information about the geological formation 12 that can be determined by the optical radiation tool 70. By way of example, identifying the signature of oil from optical measurements through the diamond window assemblies 74 may provide a guide for geo-steering to keep a borehole trajectory within boundaries of layers.

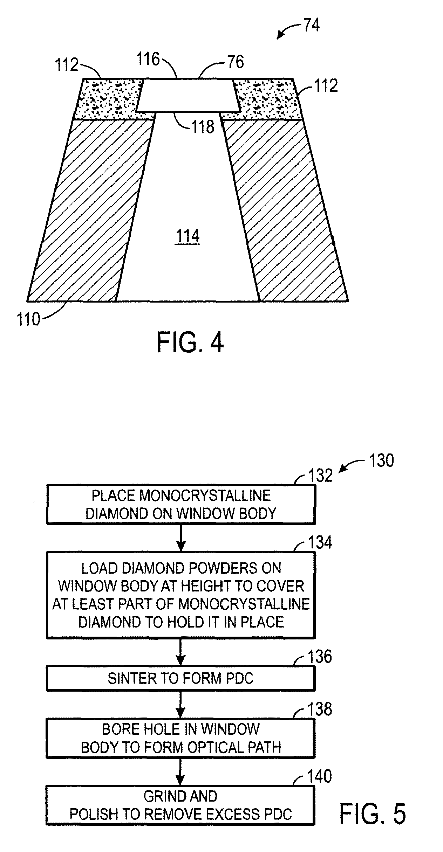

The window assemblies 74 thus may be constructed to survive the severe stress that can occur when compressing and/or scraping the window assemblies 74 against the geological formation 12. In one example, shown in FIG. 4, the window assembly 74 includes a window body 110, upon which the monocrystalline diamond window 76 is attached. In some embodiments, the monocrystalline diamond window 76 is attached by a polycrystalline diamond compound (PDC) 112 without any intervening adhesive layers between the PDC 112 and the monocrystalline diamond window 76. Instead, the PDC 112 may fuse to the monocrystalline diamond window 76 to hold the monocrystalline diamond window 76 in place. The fused PDC 112 and monocrystalline diamond window 76 may have a substantially uniform hardness and may be substantially integral, largely without weak points that could cause the window assembly 74 to break apart during operation. Indeed, weak points that might occur if two different types of materials were used for the window and the attaching material, or if there were intervening adhesive layers, may be avoided, and thus the window assembly 74 may be stronger than otherwise.

The window body 110 may be formed using any suitable material in which an optical cavity 114 may be generated. In one example, the window body 110 is formed using tungsten carbide (WC). The optical cavity 114 may represent a space that is bored out of the window body 110 and may be filled with a light-transmissive gas (e.g., air) or any other suitably light-transmissive material (e.g., clear epoxy). The monocrystalline diamond window 76 may be disposed over the optical cavity 114. In some embodiments, such as the embodiment shown in FIG. 4, the monocrystalline diamond window 76 may be a diamond disk that has an exterior-facing surface 116 with less surface area than an interior-facing surface 118.

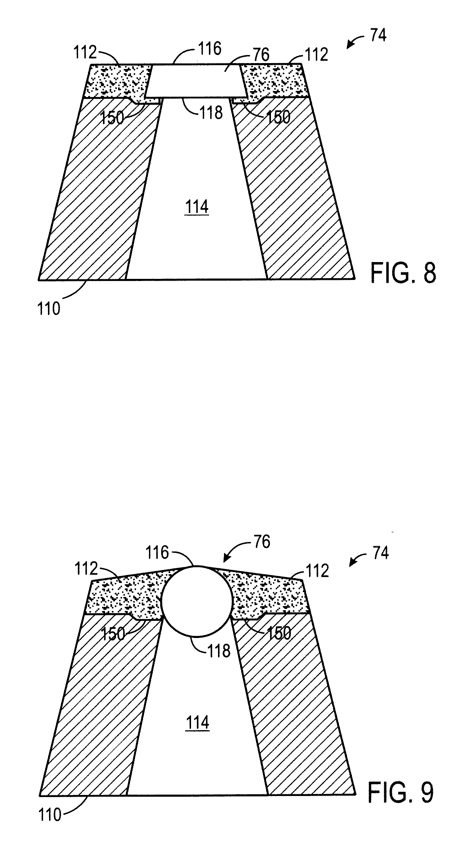

In this way, the PDC 112 may more securely hold the monocrystalline diamond window 76. It should be appreciated, however, that the monocrystalline diamond window 76 may have any suitable shape that allows the PDC 112 to securely hold the monocrystalline diamond window 76 in place. For example, as will be discussed below with reference to FIG. 9, the monocrystalline diamond window 76 may have a spheroid shape. In some examples, the vertical cross-section of the monocrystalline diamond window 76 can be rectangular. Or it can be trapezoidal with 60° - 80° base angle, as illustrated in FIG. 4. The latter may be better held in place by the PDC 112. In some examples, the monocrystalline diamond window 76 is about 5 *mm* in diameter and about 1 *mm* in thickness. The diameter may be sufficiently larger than a designed optical aperture. For instance, in some examples, the PDC 112 may overlap at least 1 *mm* rim of the monocrystalline diamond window 76. This may provide support to withstand the shear force of being scraped against the geological formation 12.

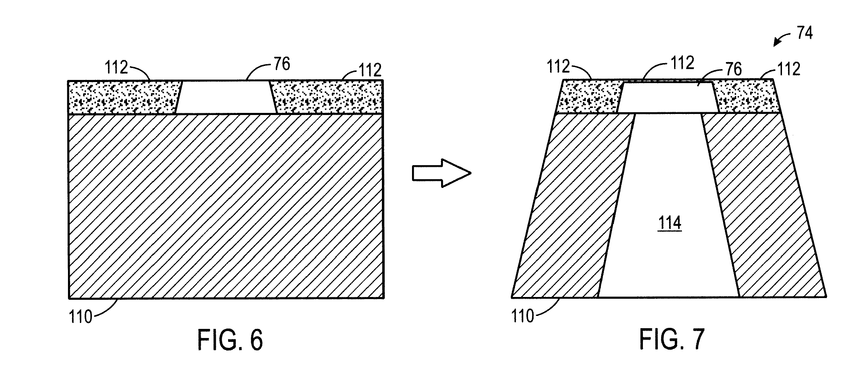

A flowchart 130 of FIG. 5 describes a method for manufacturing the window assembly 74 shown in FIG. 4. Specifically, the monocrystalline diamond window 76 maybe placed on a solid material (e.g., tungsten carbide) that will ultimately become the window body 110 (block 132). Diamond powders may be loaded on the upper surface of the window body 110 at a height sufficient to cover at least part of the monocrystalline diamond window 76 sufficiently to hold it in place (block 134). With sintering at sufficiently high heat and pressure (e.g., on the order of about 2000° C and 10⁶ *psi*)*,* the diamond powders may form the polycrystalline diamond compound (PDC) 112 (block 136). As shown in FIG. 6, the PDC 112 thus may form and fuse to the monocrystalline diamond window 76 on top of the solid window body 110 to form a substantially integral diamond material. Because the PDC 112 also fuses to the solid window body 110, the PDC 112 and the monocrystalline diamond window 76 are connected to the window body 110. Before continuing, it should be noted that a thin line of water-based adhesive can be used to glue the monocrystalline diamond window 76 on the surface of the window body 110 before sintering. This may prevent diamond powders from getting underneath the monocrystalline diamond window 76, which could damage the transparency of the interior-facing surface 118 of the monocrystalline diamond window 76. The water-based adhesive may not leave any trace after sintering.

Returning to the flowchart 130 of FIG. 5, a hole may be bored into the window body 110 to form the optical cavity 114 (block 138). Additional material may also be removed to give the window body 110 a more trapezoidal shape that may be less likely to stick in the geological formation 12. For this action of block 138, electrical discharge machining (EDM) may be appropriate. The monocrystalline diamond window 76 is non-conductive, which naturally stops EDM. Thus, using EDM to bore the optical cavity 114 may prevent harm to the diamond surface of the monocrystalline diamond window 76.

As seen in FIG. 7, this may result in a substantially complete window assembly 74, except that additional PDC 112 may have formed over the monocrystalline diamond window 76. If this excess PDC 112 were allowed to remain, it could obscure the light transmissiveness of the monocrystalline diamond window 76. As such, as described in FIG. 5, the window assembly 74 may be ground and polished to remove the excess PDC 112 (block 140). Here, it may be noted that having the PDC 112 higher than the monocrystalline diamond window 76 may prevent grinding the monocrystalline diamond window 76 to make the exterior-facing surface 116 flat, which is more difficult to do than polishing the PDC 112. Moreover, polishing the inner surface of the monocrystalline diamond window 76 may be very difficult. Therefore, keeping it free from diamond powders before sintering may assist in the manufacturing process. Once the window assembly 74 is made, it can be ground to different shapes in accordance with designs of application. For fluorescence logging, for example, a cone shape may be formed as shown in FIG. 4. The small cone-shaped window assembly 74 helps it cut into the geological formation 12, thereby providing better contact with the geological formation 12. For logging-while-drilling, on the other hand, the monocrystalline diamond window 76 may be larger than a wireline configuration because a relatively smaller size may weaken the structure. During drilling, the window assembly 74 may suffer enormous force of impact. A larger monocrystalline diamond window 76 may cause the window assembly 74 to be more durable. Having removed the excess PDC 112, the window assembly 74 shown in FIG 4 may be produced.

To provide additional support, the window body 110 of certain embodiments of the window assembly 74 may have rim grooves 150, as shown in FIG. 8. The rim grooves 150 may be milled or ground out of the window body 110 before the monocrystalline diamond window 76 is placed onto the window assembly. For example, forming the rim grooves 150 may occur before the actions of block 132 of the flowchart 130 of FIG. 5 and the window assembly 74 of FIG. 8 may be produced. In some embodiments, after the rim grooves 150 are formed but before the monocrystalline diamond window 76 is placed on the window body 110, a first amount of diamond powder may be loaded onto the window body 110 to cover the rim grooves. Afterward, the monocrystalline diamond window 76 may be placed onto the window body 110. In other embodiments, the diamond powders may be loaded after the monocrystalline diamond window 76 is placed onto the window body 110. The diamond powders may be loaded so that the diamond powders are both above and below at least part of the resulting PDC 112 is above and below the monocrystalline diamond window 76 after sintering.

Although the examples discussed above have involved a monocrystalline diamond window 76 shaped like a disk, other shapes may be employed. For example, as shown in FIG. 9, the monocrystalline diamond window 76 may also take on a spheroid shape (e.g., a sphere or oblong spheroid). In any case, at least some edges of the exterior-facing surface 116 may be covered by the PDC 112 to hold the monocrystalline diamond window 76 in place. In some embodiments, the monocrystalline diamond window 76 may be shaped to be a lens that focuses the light that is emitted or detected through the window assembly 74.

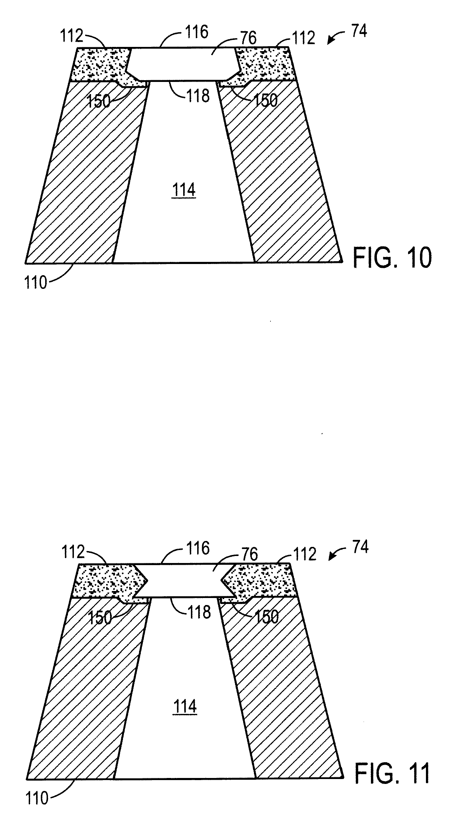

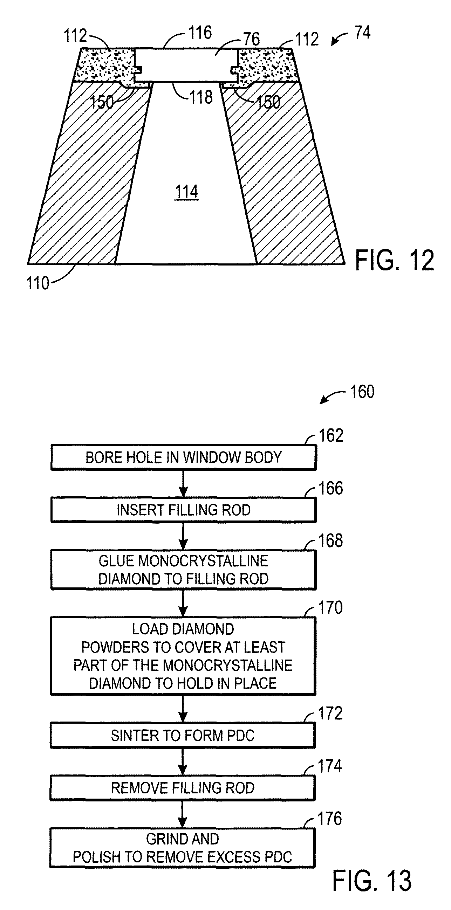

The monocrystalline diamond window 76 may take any other suitable shape that allows the PDC 112 to cover at least part of a lateral surface of the monocrystalline diamond window 76 that is at least partly facing upwardly. For example, as shown in FIG. 10, to hold the monocrystalline diamond window 76 in place on the window assembly 74, a lateral surface between the exterior-facing surface 116 and the interior-facing surface 118 of the monocrystalline diamond window 76 may form an angle other than 90 degrees between either the exterior-facing surface 116 or the interior-facing surface 118. Thus, in one example, the lateral surface of the diamond windows comprises two portions angled relative to one another and joining between the exterior and interior facing surfaces : a first portion adjacent to the exterior-facing surface 116 of the monocrystalline diamond window 76 that may form an angle greater than 90 degrees with the exterior-facing surface 116, and a second portion adjacent to the interior-facing surface 118 that may form an angle greater than 90 with the interior-facing surface 118. In another example, shown in FIG. 11, this configuration may be reversed. Here, the first portion of the lateral surface adjacent to the exterior-facing surface 116 of the monocrystalline diamond window 76 forms an angle of less than 90 degrees with the exterior-facing surface 116, and the second portion of the lateral surface adjacent to the interior-facing surface 118 forms an angle of less than 90 degrees with the interior-facing surface 118. In another example, shown in FIG. 12, a groove in the lateral surface of the monocrystalline diamond window 76 may allow the PDC 112 to adhere to the monocrystalline diamond window 76 and hold it in place on the diamond window assembly 74. In any case, the monocrystalline diamond window 76 may be shaped to allow the PDC 112 to at least partly cover a surface of the monocrystalline diamond window 76 in a way that would generally result in force having at least a partly downward vector, on the monocrystalline diamond compound 76 even when great pressure is applied to the diamond window assembly 74.

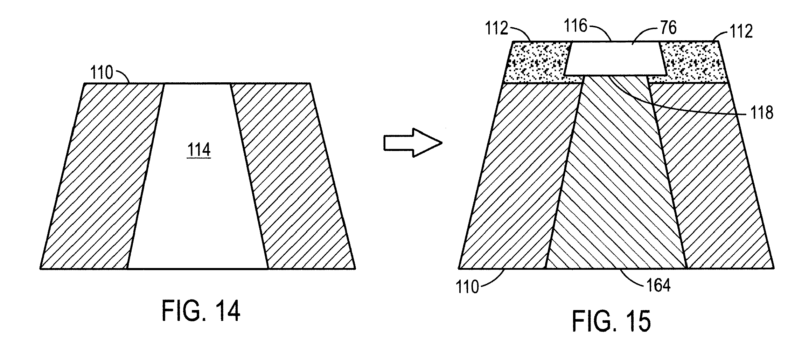

The window assemblies 74 may be formed in other ways than generally described in FIG. 5. Indeed, as described by a flowchart 160 of FIG. 13, the optical cavity 114 of the window body 110 maybe formed before the monocrystalline diamond window 76 and PDC 112 are sintered in place. In the flowchart 160 of FIG. 13, a hole is first formed in the window body 110 to produce the optical cavity 114 (block 162). This is shown in FIG. 14, which represents a cross-sectional schematic view of the formation of the window assembly 74. A filling rod 164 (FIG. 15) may be formed inside the optical cavity 114 (block 166), upon which the monocrystalline diamond window 76 may be glued (block 168) while diamond powders are loaded (block 170) and sintered to form the PDC 112 (block 172). The filling rod 164 may be any suitable material, and may be pyrophyllite in some cases.

Because the filling rod 164 may be formed to extend slightly beyond the window body 110, the monocrystalline diamond window 76 may also extend above the window body 110, as shown in FIG. 15. This may allow the PDC 112 to be formed both above and below the monocrystalline diamond window 76. The distance that the filling rod extends above the window body 110 may be any suitable distance that allows the PDC 112 to be formed beneath the monocrystalline diamond window 76 (e.g., about 0.5 mm). Note also that extending the filling rod 164 to allow the PDC 112 to be formed underneath the monocrystalline diamond window 76 may occur in conjunction with, or in lieu of, rim grooves such as the rim grooves 150 shown in FIG. 8. Returning to the flowchart 160 of FIG. 13, after forming the PDC 112 around the monocrystalline diamond window 76 at block 172, the filling rod 164 may thereafter be removed (block 174). Any excess PDC 112 may be removed by grinding and/or polishing (block 176). Note that the process of FIG. 13 may preserve the optical quality of the interior-facing surface 118 of the monocrystalline diamond window 76. Namely, as compared to the process of FIG. 5, the window body 110 material may be fully removed, since it may be difficult to fully machine away the window body 110 material after the monocrystalline diamond window 76 is installed.

The specific embodiments described above have been shown by way of example, and it should be understood that these embodiments may be susceptible to various modifications and alternative forms. It should be further understood that the claims are not intended to be limited to the particular forms disclosed, but rather to cover modifications, equivalents, and alternatives falling within the spirit and scope of this disclosure.

## Claims

1. A method comprising:
placing a downhole tool in a wellbore in a geological formation;
compressing a window assembly disposed in the downhole tool against the geological formation, wherein the window assembly comprises a polycrystalline diamond compound material fused with a monocrystalline diamond window to hold the monocrystalline diamond window in place despite being compressed against the geological formation;
emitting first photonic radiation through the monocrystalline diamond window onto the geological formation; and
detecting second photonic radiation through the monocrystalline diamond window,
wherein the second photonic radiation derives from one or more interactions between the first photonic radiation and the geological formation, wherein the second photonic radiation varies depending on a composition of the geological formation and thus carries information relating to the composition of the geological formation.

2. A method according to claim 1, wherein placing the downhole tool in the wellbore comprises drilling the wellbore using a borehole assembly (BHA) that contains the downhole tool.

3. A method according to claim 1, wherein placing the downhole tool in the wellbore comprises placing the downhole tool in the wellbore after the wellbore has been drilled.

4. A method according to any one of the preceding claims, wherein the window assembly is compressed against the geological formation by scraping the window assembly against the geological formation, wherein the window assembly protrudes from a housing surface of the downhole tool.

5. A method according to any one of the preceding claims, wherein the window assembly is compressed against the geological formation by scraping the window assembly against the geological formation, wherein the polycrystalline diamond compound material that holds the monocrystalline diamond window in place does so without an intervening adhesive material, thereby allowing the monocrystalline diamond window to remain in place despite being scraped against the geological formation.

6. A downhole device comprising:
a window assembly to enable photonic radiation to enter or exit the downhole device, wherein the window assembly comprises:
a window body having a transparent interior portion that is substantially transparent to the photonic radiation;
a monocrystalline diamond window disposed over the transparent interior portion of the window body; and
a polycrystalline diamond compound material disposed around the monocrystalline diamond window on the window body, wherein the polycrystalline diamond compound is fused with the monocrystalline diamond window to hold the monocrystalline diamond window in place without any additional intervening adhesive material; and
a photonic-radiation-based tool configured to emit or detect, or emit and detect, the photonic radiation through the window assembly during a well logging operation.

7. A downhole device according to claim 6, wherein the window assembly is disposed on a stabilizer blade of the downhole device or on a drill bit of a borehole assembly (BHA), or a combination thereof.

8. A downhole device according to claim 6, wherein the downhole device is configured to be used in a conveyance of wireline, slickline, coiled tubing, or a combination thereof, and wherein the window assembly protrudes from a housing of the downhole device.

9. A downhole device according to any of claims 6 to 8, wherein the polycrystalline diamond is also disposed between at least part of the monocrystalline diamond window and the window body.

10. A downhole device according to any of claims 6 to 9, wherein the monocrystalline diamond window comprises a lateral surface occurring at least partly between a first surface of the monocrystalline diamond window that is substantially not covered by the polycrystalline diamond compound and a second surface of the monocrystalline diamond window that is substantially not covered by the polycrystalline diamond compound, wherein the lateral surface is angled in relation to the window body to cause the polycrystalline diamond compound to hold the monocrystalline diamond in place when the window assembly is pressed against a formation during the logging operation.

11. A downhole device according to claim 10, wherein the monocrystalline diamond window comprises a diamond disk, wherein the first surface comprises an interior-facing surface and wherein the second surface comprises an exterior-facing surface, wherein the interior-facing surface has a greater amount of surface area than the exterior-facing surface

12. A downhole device according to claim 10, wherein the monocrystalline diamond window comprises a diamond spheroid.

13. A method for manufacturing a diamond window assembly for photonic-radiation-based logging, the method comprising:
disposing a monocrystalline diamond over a window body;
loading diamond powders over the assembly of the monocrystalline diamond and the window body;
sintering the diamond powders to form a polycrystalline diamond compound that fuses with the monocrystalline diamond and the window body to hold the monocrystalline diamond on the window body; and
removing excess polycrystalline diamond compound on the monocrystalline diamond by grinding, or polishing, or both grinding and polishing.

14. A method according to claim 13, comprising:
before loading the diamond powders:
disposing the monocrystalline diamond over the window body by placing the monocrystalline diamond on the window body, wherein the window body comprises a solid material; and
after sintering the diamond powders:
boring a hole in the window body beneath the monocrystalline diamond window to form an optical path through the window body to the monocrystalline diamond window.

15. A method according to claim 13, comprising:
before loading the diamond powders:
boring a hole in the window body to form an optical path;
inserting a filling rod in the hole in the window body; and
disposing the monocrystalline diamond over the window body by adhering the monocrystalline diamond to the filling rod; and
after sintering the diamond powders:
removing the filling rod, leaving the monocrystalline diamond attached to the window body by the polycrystalline diamond compound.

16. A method according to any of claims 13 to 15, wherein the diamond powders are loaded over the monocrystalline diamond, wherein the monocrystalline diamond comprises a shape in which, after sintering and removing the excess polycrystalline diamond compound, edges of the monocrystalline diamond remain covered by the polycrystalline diamond compound to hold the monocrystalline diamond in place.
